# EUROPEAN PATENT APPLICATION

(11) **EP 3 505 346 A1**
(43) Date of publication of application: **03.07.2019**
(21) Application number: 18185196.5
(22) Date of filing: 24.07.2018
(51) Int. Cl.: B32B 37/06, B32B 41/00, B30B 15/06, B32B 17/10

(54) **LAMINATION HEAT PLATE BASED ON ELECTRIC HEATING, AND ELECTRIC HEATING SYSTEM FOR LAMINATION HEAT PLATE**

(30) Priority: 26.12.2017 CN 201721856373 U
(71) Applicant: Beijing Juntai Innovation Technology Co., Ltd, 100176 Beijing (CN)
(72) Inventor: Cai, Cen, Beijing, 100176 (CN); Li, Liangsheng, Beijing, 100176 (CN); Fan, Huibin, Beijing, 100176 (CN)
(74) Representative: Meissner Bolte Partnerschaft mbB

(57) **Abstract**

A lamination heat plate based on electric heating is disclosed. The lamination heat plate is provided with a lamination zone for placing a module, and a heat preservation zone at the edge; a plurality of electric heating elements and temperature sensors that are evenly arranged are provided in the lamination zone and the heat preservation zone respectively, and the number of the electric heating elements is more than that of the temperature sensors; and the electric heating elements and the temperature sensors are respectively electrically connected to heating controllers. The invention can effectively ensure the overall temperature uniformity of the lamination heat plate in the lamination process, and can solve the problem of uneven temperature between the edge of the lamination heat plate and the middle portion where the module is placed caused by conventional oil heating. Therefore, the heating method of the invention has advantages of high accuracy of temperature control, high heating speed, energy saving or the like, and can improve the productivity of the laminating equipment and the yield rate of battery modules. An electric heating system for a lamination heat plate is further disclosed.

## Description

### TECHNICAL FIELD

The invention relates to the field of solar module packaging technology, and in particular to a lamination heat plate based on electric heating and an electric heating system for the lamination heat plate.

### BACKGROUND

In the packaging process of a solar module, the lamination process is a very important process step. The solar module composed of a glass substrate, an interlayer adhesive film material and an edge sealing material is pressed by a laminator under a vacuum condition and is heated. The glass and the adhesive film are firmly bonded together by means of a segment lamination process, thus achieving the sealing effect and guaranteeing the operational function of the module. The temperature uniformity of the lamination heat plate used in the lamination process plays a decisive role in the lamination effect.

The conventional lamination heat plate is heated by using the oil heating method, which mainly includes circulating the heat conducting oil inside the lamination heat plate through the control of a valve after the heat conducting oil is heated externally to a certain temperature, and transferring the heat to the lamination heat plate via heat conduction so as to achieve the temperature required for the lamination process.

However, there are many disadvantages in this heating method, such as a slow temperature-rising rate and high energy consumption. Since it is required to heat the entire circulation system, the dynamic control of temperature has a slow response, and the accuracy in the temperature control is directly affected by the denseness of oil passages and the thicknesses of oil transporting conduits inside the lamination heat plate. Furthermore, an effective heat preservation measure is lacked at joints of the pipelines leading to the heat plate, which may lead to a terrible heat dissipation situation, resulting in fast heat dissipation in the periphery of the lamination heat plate and slow heat dissipation in the middle of the lamination heat plate, and further affecting the productivity and the yield rate.

### SUMMARY

In view of the problem of non-uniform temperature due to slow heating and uneven heat distribution in various zones of the lamination heat plate in the lamination process of the module, the invention aims to provide a lamination heat plate based on electric heating and an electric heating system for the lamination heat plate, in order to achieve a precise control of temperature in individual zones and to ensure temperature uniformity of the lamination process.

The following technical solutions are adopted in the invention.

A lamination heat plate based on electric heating is provided, which comprises a lamination zone for placing a module, and a heat preservation zone at the edge;
a plurality of electric heating elements and temperature sensors that are evenly arranged are provided in the lamination zone and the heat preservation zone respectively, and the number of the electric heating elements is more than that of the temperature sensors; and
the electric heating elements and the temperature sensors are respectively electrically connected to heating controllers.

Optionally, the lamination zone and the heat preservation zone further each include a plurality of temperature control sub-zones, and there are a plurality of the electric heating elements and at least one of the temperature sensors in each of the temperature control sub-zones; and
the number of the heating controllers is the same as that of the temperature control sub-zones, and the electric heating elements and the temperature sensor in one of the temperature control sub-zones are respectively electrically connected to a corresponding one of the heating controllers.

Optionally, the density of the electric heating elements arranged in the heat preservation zone is greater than that of the electric heating elements in the lamination zone.

Optionally, the electric heating elements and the temperature sensors are embedded in the lamination heat plate.

Optionally, the electric heating elements are graphite electrode heaters.

Optionally, the lamination heat plate is a steel plate.

Optionally, the steel plate has a thickness of 60mm to 100mm.

An electric heating system for a lamination heat plate is provided, which comprises:
heating controllers, an over-temperature alarm unit, and the above-described lamination heat plate;
wherein the heating controllers are electrically connected to the over-temperature alarm unit and the electric heating elements and the temperature sensors of the lamination heat plate, respectively.

Optionally, the heating controller is a programmable controller having a built-in PID algorithm.

Optionally, the heating controller is provided with a control screen for setting control parameters and for displaying alarm information.

According to the invention, the lamination heat plate is heated and controlled in individual zones by way of electric heating; in particular, a heat preservation zone is arranged at the edge of the heat plate which is not in contact with the module, thereby effectively ensuring the overall temperature uniformity of the lamination heat plate in the lamination process, and solving the problem of uneven temperature between the edge of the lamination heat plate and the middle portion where the module is placed caused by conventional oil heating. Therefore, the heating method of the invention has advantages of high accuracy of temperature control, high heating speed, energy saving or the like, and can improve the productivity of the laminating equipment and the yield rate of battery modules.

### BRIEF DESCRIPTION OF THE DRAWINGS

In order to make the object, technical solutions, and advantages of the invention clearer, the invention is further described below with reference to the accompanying drawings, in which:
Fig. 1 is a schematic diagram of a lamination heat plate based on electric heating according to an embodiment of the present invention;
Fig.2 is a schematic diagram of a lamination heat plate based on electric heating according to a preferred embodiment of the present invention.

### Description of reference numbers:

1 lamination zone, 2 heat preservation zone, 3 electric heating element, 4 temperature sensor, 5 temperature control sub-zone.

### DETAILED DESCRIPTION

Embodiments of the invention are described in detail below. Examples of the embodiments are illustrated in the accompanying drawings, throughout which identical or similar reference numerals denote identical or similar elements or elements having identical or similar functions. The embodiments described below with reference to the drawings are exemplary in nature and are used merely to explain the invention, and cannot be construed as limiting the invention.

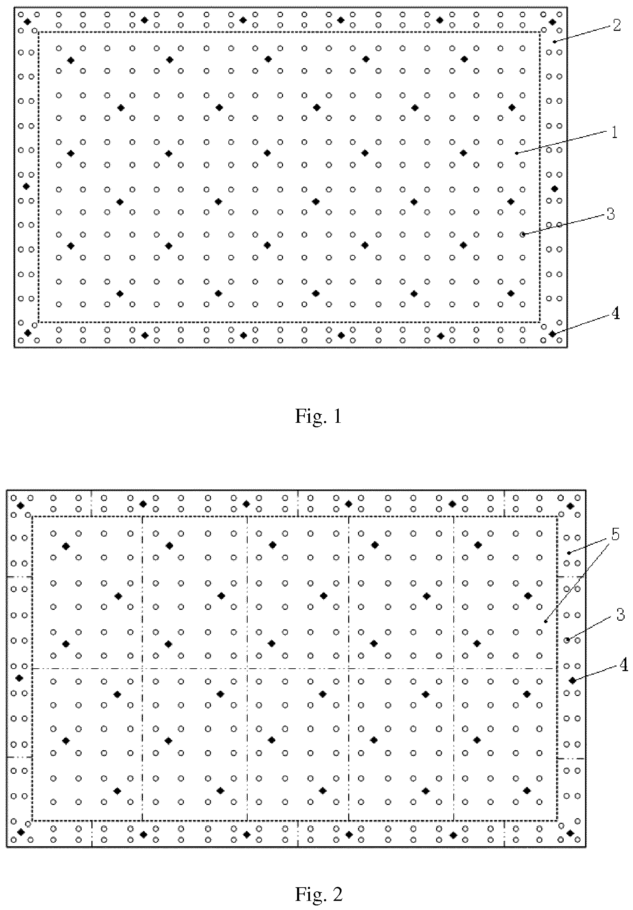

A lamination heat plate based on electric heating is provided according to an embodiment of the invention. As shown in Fig. 1, the lamination heat plate is divided into two main zones (indicated by short broken lines in Fig.1) according to the functions, that is, a lamination zone 1 where the module is placed, and a heat preservation zone 2 at the edge of the lamination heat plate. The heat preservation zone 2 refers to periphery zones on the lamination heat plate which generally are not in contact with the module and at which heat can be more easily dissipated. In this invention, since this zone is also provided with the electric heating function, the heat dissipation rate can be effectively reduced so as to realize heat preservation, and therefore this zone is named as the heat preservation zone 2.

Specifically, a plurality of electric heating elements 3 and temperature sensors 4 which are evenly arranged are provided in the lamination zone 1 and the heat preservation zone 2 respectively, and the electric heating elements 3 and the temperature sensors 4 are respectively electrically connected to heating controllers (not shown in Fig.1). The electric heating elements 3 and the temperature sensors 4 may be embedded or inlaid in the lamination heat plate so that the surfaces of the electric heating elements 3 and the temperature sensitive zones of the temperature sensors 4 fully contact with the lamination heat plate. It should be noted that the type of the electric heating elements 3 may be various, such as a graphite electrode heater or an infrared radiation heater, etc.

Still referring to Fig.1, the number of the electric heating elements 3 may be more than that of the temperature sensors 4. In practical operation, the specific numbers and arrangement of the electric heating elements 3 and the temperature sensors 4 are not limited to those shown in Fig. 1, and can be adjusted as actually required, as long as the uniformity of distribution can be ensured. However, it should be noted that reference is preferably made to what is shown in Fig.1, and the density of the electric heating elements 3 arranged in the heat preservation zone 2 can be greater than that of the electric heating elements 3 in the lamination zone 1. Therefore, the heat preservation effect of the heat preservation zone 2 can be improved to a certain extent.

The operational principle of the above embodiment is described as follows.

According to the set process temperature, the electric heating elements 3 distributed throughout the lamination zone 1 and the heat preservation zone 2 are controlled by the heating controllers to heat the lamination heat plate so that the temperature of the lamination heat plate rises, and the temperature of the heat plate is adjusted by the heating controllers in real time based on the temperature signals fed back by the evenly distributed temperature sensors 4. Therefore, an effective control of the temperature uniformity is realized. Of course, it should be understood by those skilled in the art that different preset parameters and heating strategies can be set for the lamination zone 1 and the heat preservation zone 2 respectively, and the invention has no limitation to this herein. It can be seen that the lamination heat plate according to the invention has less heat loss and higher heating speed. Therefore, not only the productivity of the equipment is ensured, but also energy is saved. As compared with the conventional oil heating method in which the temperature compensation that can be provided by oil heating has a slow response when the cross-link degree of the battery modules is not uniform in the lamination process, the electric heating method of the invention can rapidly compensate temperature for various zones of the lamination heat plate. The temperature uniformity in the entire lamination process is therefore ensured, and the yield rate and the productivity of the solar battery module are improved.

Based on the above embodiment, a preferred solution with zone subdivision and multi-path heating is further provided according to the invention. In the preferred embodiment shown in Fig. 2, the above described lamination zone 1 and heat preservation zone 2 each are divided into a plurality of temperature control sub-zones 5 (indicated by the double-dotted broken lines in Fig.2). A plurality of the above described electric heating elements 3 and at least one temperature sensor 4 are arranged in each of the temperature control sub-zones 5. Moreover, the number of heating controllers may be the same as that of the temperature control sub-zones so that the electric heating elements 3 and the temperature sensor 4 in one of the temperature control sub-zones 5 are electrically connected to one corresponding heating controller, and thus a plurality of independently controlled temperature control zones are formed. As such, the temperature control sub-zones 5 are associated with each other, and a function of complementing each other is realized, thus effectively avoiding the problem that the temperature in the middle of the lamination heat plate is high, and the temperature at the periphery of the lamination heat plate is too low due to rapid heat dissipation. Therefore, the overall temperature uniformity of the lamination heat plate can be controlled to be within a tiny fluctuation range.

Further, the material of the aforementioned lamination heat plate can be various. In another preferred solution of the present invention, a steel plate with a thickness of 60mm to 100mm is used. The reason why the steel plate is preferred rather than an aluminum plate or a copper plate is that both the heat conductivity and the bearing strength need to be comprehensively considered in the invention. Although the heat conductivity of steel is lower than that of aluminum or copper, the lamination heat plate needs to have good pressure bearing ability, and steel is superior to aluminum or copper in terms of pressure bearing. Moreover, the deficiency in heat conductivity can be completely compensated by the electric heating method provided by the invention. Regarding the thickness of the aforementioned steel plate, a preferred reference range is provided by the invention after a comprehensive consideration of both the heat conductivity and the pressure bearing ability. For example, a steel plate with a thickness of 80mm may be used as the aforementioned lamination heat plate in a specific implementation.

In combination with the above-described embodiments of the lamination heat plate, an electric heating system for the above-described lamination heat plate is further provided according to the invention. The system comprises: heating controllers, an over-temperature alarm unit, and the lamination heat plate mentioned in the previous embodiments and preferred solutions. The heating controllers are electrically connected to the over-temperature alarm unit and the electric heating elements and the temperature sensors of the lamination heat plate, respectively. Of course, in practical operation, the heating controller may be a programmable controller (PLC) or a temperature control instrument or the like. More preferably, a PID algorithm may be built in the heating controller to achieve an accurate closed-loop control. The aforementioned over-temperature alarm unit is provided for the purpose of protecting the equipment or module from being damaged by high temperature, since there is a risk of maladjustment of temperature control in the case of the electric heating method used in the present invention. The over-temperature alarm unit can be triggered to send an alarm in a case that over temperature is detected by the heating controller via the temperature sensor. It should be noted here that, in another embodiment of this system, the aforementioned heating controller is further provided with a control screen for setting control parameters and for displaying alarm information. In this way, when an over-temperature condition occurs, a warning signal can be synchronously sent to the operator via the control screen in conjunction with the over-temperature alarm unit, and the corresponding over-temperature time point and temperature value can be recorded as a reference for maintenance at a later stage.

The specific operation mode may be described as follows. The heating controllers control the electric heating elements to heat the lamination heat plate, and a PID closed-loop control is performed on the electric heating elements based on the temperature fed back by the temperature sensors. When the temperature reaches or exceeds the set temperature value, the over-temperature information will be displayed on the control screen. At the same time, the over-temperature alarm unit may emit acousto-optic signals. The heating controllers will perform protection measures such as heating and power-off or temperature control and adjustment so as to systematically achieve an accurate and reliable control over the lamination heat plate based on electric heating.

While the constructions, features, and effects of the invention have been described above in detail with reference to the embodiments shown in the drawings, the above description merely relates to the preferred embodiments of the invention. It should be noted that the technical features involved in the above-described embodiments and the preferred modes thereof can be reasonably combined into a variety of equivalent solutions by those skilled in the art without departing from or changing the design concepts and technical effects of the invention. Therefore, the invention is not limited to the scope of implementations shown in the drawings. Any change based on the concept of the invention or any equivalent embodiment with equivalent variations should fall within the scope of protection of the invention if it does not go beyond the scope covered by the description and the drawings.

## Claims

1. A lamination heat plate based on electric heating, comprising a lamination zone (1) for placing a module, and a heat preservation zone (2) at the edge;
wherein a plurality of electric heating elements (3) and temperature sensors (4) that are evenly arranged are provided in the lamination zone (1) and the heat preservation zone (2) respectively, and the number of the electric heating elements (3) is more than that of the temperature sensors (4); and
the electric heating elements (3) and the temperature sensors (4) are respectively electrically connected to heating controllers.

2. The lamination heat plate according to claim 1, wherein the lamination zone (1) and the heat preservation zone (2) further each include a plurality of temperature control sub-zones (5), and there are a plurality of the electric heating elements (3) and at least one of the temperature sensors (4) in each of the temperature control sub-zones (5); and
the number of the heating controllers (3) is the same as that of the temperature control sub-zones (5), and the electric heating elements (3) and the temperature sensor (4) in one of the temperature control sub-zones (5) are respectively electrically connected to a corresponding one of the heating controllers.

3. The lamination heat plate according to claim 1, wherein the density of the electric heating elements (3) arranged in the heat preservation zone (2) is greater than that of the electric heating elements (3) in the lamination zone (1).

4. The lamination heat plate according to any one of claims 1 to 3, wherein the electric heating elements (3) and the temperature sensors (4) are embedded in the lamination heat plate.

5. The lamination heat plate according to any one of claims 1 to 3, wherein the electric heating elements (3) are graphite electrode heaters.

6. The lamination heat plate according to any one of claims 1 to 3, wherein the lamination heat plate is a steel plate.

7. The lamination heat plate according to claim 6, wherein the steel plate has a thickness of 60mm to 100mm.

8. An electric heating system for a lamination heat plate, comprising:
heating controllers, an over-temperature alarm unit, and the lamination heat plate according to any of claims 1 to 7;
wherein the heating controllers are electrically connected to the over-temperature alarm unit and the electric heating elements and the temperature sensors of the lamination heat plate, respectively.

9. The electric heating system according to claim 8, wherein the heating controller is a programmable controller having a built-in PID algorithm.

10. The electric heating system according to claim 8 or 9, wherein the heating controller is provided with a control screen for setting control parameters and for displaying alarm information.
